# EUROPEAN PATENT APPLICATION

(11) **EP 1 734 537 A2**
(43) Date of publication of application: **20.12.2006**
(21) Application number: 06006812.9
(22) Date of filing: 31.03.2006
(51) Int. Cl.: G11C 29/56

(54) **Bitmap analysis system and method for high speed testing of a memory device**

(30) Priority: 31.03.2005 IN de07112005
(71) Applicant: STMicroelectronics Pvl. Ltd., 3 & 18, Sector 16A, Institutional Area Noida, Uttar Pradesh 201 301 (IN)
(72) Inventor: Dubey, Prashant, Indirapuram Ghaziabad, UP (IN)
(74) Representative: Ferrari, Barbara

(57) **Abstract**

The invention provides a Bitmap analysis system or BMAS for high-speed testing a memory device (30). The system comprises:
a test engine (38) connected to the memory device (30) for generating bitmaps; and
a First-In First-Out, or FIFO block (31) having a write terminal connected to the test engine (38) and a read terminal connected to a tester (39);

wherein
the memory device (30) is partitioned into small equal sized memory segments;
the FIFO block (31) contains at least one FIFO segment equivalent to the size of said memory segments; and
the test engine (38) sequentially generates and verifies the bitmaps of each of the memory segment.

## Description

### Field of Invention

The present invention relates to a bitmap analysis system for high-speed testing of a memory device.

### Background of the Invention

The semiconductor industry has intensified its focus on yield issues to meet the challenges of manufacturing devices at sub nanometer and below. The important step in correcting the existing manufacturing yield issues is finding the defects into the manufactured devices, in particular memory devices. For this reason, an important component of a comprehensive test methodology is an effective embedded memory testing.

With reference to logic circuitry, the redundant nature of a memory structure makes it easier to pinpoint locations of defects, in many cases down to specific transistors comprised into such a memory structure.

Recent technology advances in the so/called memory. Built-In-Self-Test (usually indicate by the acronym BIST) have made it the most prevalent method for embedded memory testing.

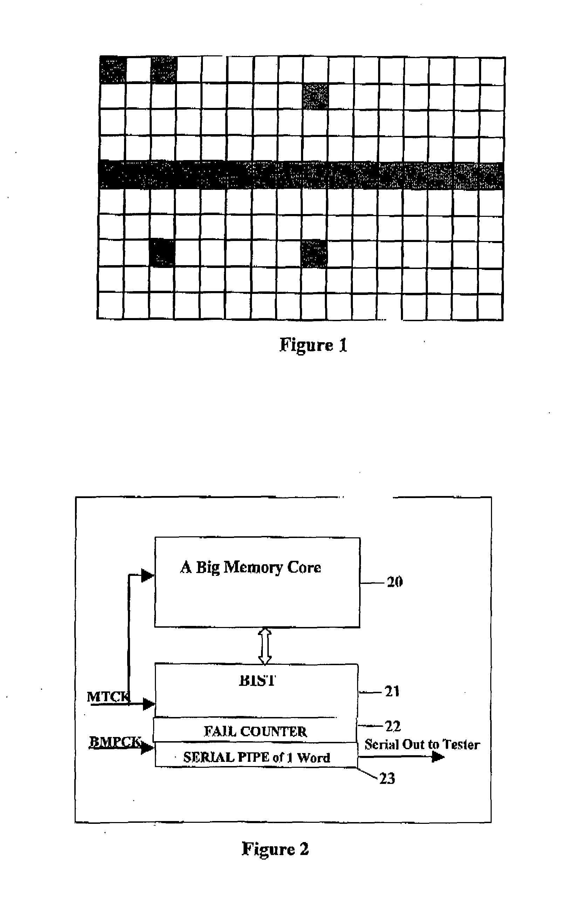

More particularly, in a memory test method of the BIST type, bitmap or failure map is an important feature. In fact, if somehow a snapshot of the core of a memory device is taken, it can be possible, by seeing the pattern of such snapshot, make inferences about the faults in the address decoder, or in the Input Output (I/O) circuitry or in the core of the memory device. This snapshot is known as the Bitmap of the memory device, and is generated by writing known data in the memory device and then reading and comparing each word to see which word location or bit location is failing, this raw information being used to create the Bitmap. In Fig. 1, a Bitmap of a memory device has been shown.

There are several problems that are commonly encountered while generating the Bitmap of a memory device under test or faulty memory. It is observed that more faults occur at high clock speeds for reading/writing from memory devices. However, most testers today operate at a very low clock speed as the I/O's for the testers fail at high frequencies. Due to this problem, many faults that should be detected may be missed.

The raw data for one word is normally of a good length as it contains the address of the word, the data output of the memory, the stimuli which were written. Sometimes, if the test is running at the tester's frequency, the stimuli and the address information can be left out as, by counting the number of clock cycles at which the fault occurred, the address and the stimuli can be calculated.

In addition, if test patterns are run through a tester, there is no need of the address and stimuli information, only the data output response of the memory device being enough. However, sometimes this information is also big and it takes a lot of space to store it as well to send it out to the tester. Moreover, it should be taken into account that the channels through which the tester receives the data are very few and normally only one output is available to pipe the data serially out.

All widely used current methodologies for testing memory device treat the memory blocks as macros, and hence all the faults whether they are in the address decoder or in the I/O circuitry or in the core of the memory device are finally mapped on the core.

Some of the testing devices used for generating the Bitmap of embedded memories (also indicated as Bitmap generators) are of the Serial Pipe based type, as schematically shown in Fig. 2 by means of a block diagram for this kind of testing method. '

More particularly, a memory core 20 is connected to a Built In Self-Test or BIST 21 having a Fail Counter 22 and a Serial Pipe 23. In this kind of method, whenever a fault occurs, the faulty address information is transferred to a single word of the Serial Pipe 23. The BIST 21 sends a flag to a tester (not shown) to gather the faulty address information.

Until all the bits have been read by the tester, the BIST 21 is kept on hold. In addition, the frequency of operation in this case is very low as the BIST 21 runs at the speed of the tester frequency. In case of a large number of faults, even if the BIST 21 runs at a high frequency, its waiting time will make the test run at a low speed.

In summary, this known method using a testing device of the Serial Pipe based type is not an effective technique since the process takes long time and extra software and resources are required in the tester to generate the Bitmap of the memory device under test.

Also known are Parallel First-in-First-out (FIFO) block based Bitmap generator, using a method which is an extension of the serial pipe based one.

In a Bitmap generator, instead of using a Serial pipe of one word, a Serial Pipe of N words is used. So, a FIFO block is added to the Bitmap generator structure, which stores the information of a failing word, each time the fault occurs. The FIFO block works at the BIST clock. In a parallel manner, the information is being transferred to the tester using the serial pipe 23, which shifts the information at the tester's clock.

The advantage of using a FIFO block is to interface a fast BIST with a slow tester. The drawbacks of this method are that no matter how big is the FIFO block used, the BIST waiting time for the tester to read the complete information once the stack of the FIFO block is full cannot be eliminated. Thus, the FIFO block's size, in particular height, can never be decided with surety.

In addition, the raw information to be stored is also in this case very big. Thus, considerable area and time is consumed also according to this method, while all the efforts of generating a high-speed Bitmap of the memory device under test are wasted if the stack of the FIFO block is full and the BIST has to wait.

It is also known a further Bitmap generator implementing a testing method based on a fail counter. According to this method, the BIST stops each time during the run when it encounters a fault. Every time the BIST stops, it stores all the raw information about the fault and sends it to the tester and increments the fail counter. In its next run, the BIST stops at the N+1th fault where N is the current value of the counter. Thus, the Bitmap of the memory device under test can be generated with all the information given by the BIST.

The problem of this known method is that the fail counter is highly unused if there are very few faults. In addition, if there are a large number of faults, a very big fail counter is needed and also this method needs a lot of time and hardware resources to generate the complete Bitmap of the memory device under test. In addition, this method does not generate good information in case of marginal errors where the error occurs in one run and it does not repeat itself in the next run. In these cases, the BIST skips a genuine fault.

Compression based methods are other set of techniques which are used to generate the Bitmap of a memory device under test. The problem is that the compression is always lossy; hence, a complete picture of a faulty memory is not obtained. In addition, the hardware needed for compression takes a lot of area, which is not suitable for production units where the Bitmap is only needed in case of debugging at the early stage of the Integrated Circuit (IC) product.

Hence the disadvantages of existing Bitmap generation method and architectures are as follows:
- the existing architectures are unable to generate a Bitmap of a memory device under test at very high speed.
- The time taken is very long (especially for the fail counter method).
- The transferred information is not a full Bitmap of the memory device under test but raw information, which has to be processed to get the needed Bitmap at the tester end.
- The size of the internal FIFO block is insufficient due to which the BIST may stop in the middle of the test to prevent the overflow of the stack of the FIFO block in case of fast occurring faults.
- The Bitmap generated may give wrong information in case of marginal errors.
- Some faults may get undetected in case of fail counter method, as the March elements of the algorithm are never completely run.
- If the raw information is compressed on chip then the compression is lossy as well as unsuitable for random memory address testing through the BIST.

The present invention provides a Bitmap analysis method as well as a corresponding system, which solves the problems created by the above-mentioned disadvantages of the known solutions. The new system's architecture has a low area overhead and is aimed to provide a faster execution of the diagnostic process, i.e. the testing of a memory device for detecting its faults.

### Object and Summary of the Invention

The solution idea underlying the present invention is that of splitting the step of generating the Bitmap of a memory device under test into a plurality of sub-steps performed onto small equal sized memory segments.

On the basis of such solution idea the technical problem is solved by a Bitmap analysis system for high-speed testing a memory device as defined by the characterising part of claim 1.

The problem is also solved by a method for high-speed testing a memory device as defined by the characterising part of claim 7.

The characteristics and advantages of the Bitmap analysis system and method for high-speed testing a memory device according to the invention will be apparent from the following description of embodiments thereof given by way of indicative and non limiting example with reference to the annexed drawings.

### Brief Descriptions of the Drawings

In the drawings:
Figure 1 shows a Bit Map of a memory device.
Figure 2 shows an architecture for generating a Bitmap of a memory device, realized according to the prior art.
Figure 3 shows a block diagram of a Bitmap analysis system according to the invention.

### Detailed Description of the Invention

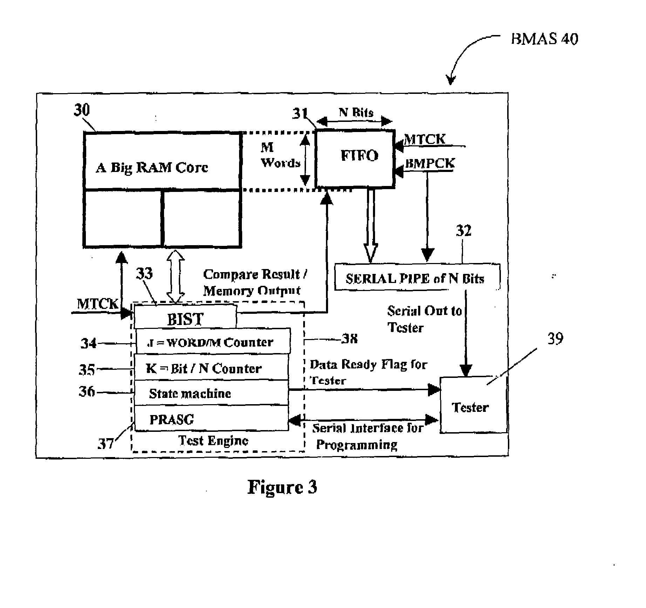

With reference to such figures, and in particular to figure 3, a Bitmap analysis system (BMAS) is schematically shown in a block diagram.

The Bitmap analysis system (BMAS) 40 according to the invention comprises a RAM core 30 of a memory device under test connected to a test engine 38, in turn comprising a Built-In-Self-Test, indicated as BIST 33 that contains a March element opcode loader and is in turn connected to a First-in-First-out (FIFO) block, indicated as FIFO 31.

In the following description, reference will be made to the RAM core or to the memory device under test by using the same reference number 30 for sake of simplicity.

In particular, the FIFO 31 has a matrix structure with M words and N data bits and is also connected to a serial pipe 32, which converts N bits to 1-bit information per tester clock. The serial pipe 32 has an output terminal connected to a tester 29.

Advantageously according to the invention, the test engine 38 includes a first counter 34 which counts up to (Total Words)/M and a second counter 35 which counts up to (Total Data Bits)/N both connected to a state machine 36 to organize all the activities and manage the handshake signals with the tester 39. The test engine 38 further includes a Programmable Read Address Sequence Generator (PRASG) 37 for configuring an address sequence from the tester 39 through a serial interface (not shown).

In this way, the Bitmap analysis system (BMAS) 40 according to the invention analyses the faults of the memory device under test whose big memory core 30 is divided into many small logical memory cores or segments. The Bitmap analysis system (BMAS) 40 thus generates a Bitmap for each segments of the core 30 that can be stored in a smaller FIFO block, which has been used as an interface between the BIST 33 and the tester 29, just like in the known architectures.

More particularly, the March element opcode loader substantially is a sequence of instructions run by the BIST 33 and a combination of various March elements, the March element opcode loader performing a so called march test. Any March element is further a combination of some write or read operations. Thus, a March element forms a complete stimulus, by which one can tell; what operations have been done on the memory device and what can be the expected data.

The March element opcode loader loads the background data to be written as well as the expected data to be taken for each FIFO 31, in terms of inverted or non-inverted data background.

The data background is sent only once at the beginning of the instructions and remain constant for all the March elements. Only the expected inverted data or non-inverted data as well as the number of operations in one March element change with each new March element.

This reduces the need to transfer the stimuli along with the Bitmap and allows the expected data bitmap at the tester to be formed.

Moreover, the FIFO 31 is used to represent a part of the core 30. Its write terminal is connected to the BIST 33 while its read terminal is connected to the tester 29. Thus, the BIST 33 writes into a first word of the FIFO 31 when it makes a first valid measurement: if the result of the memory word is false, it stores logic 1 in place of that bit, otherwise logic 0 is stored.

This activity is repeated until all the words in the current window are over.

As the BIST 33 doesn't stop during one March element run, the number of parallel FIFOs needed is equal to the number of maximum operations in any of the March elements.

As soon as the FIFO 31 is full, the state machine 36 generates a flag for the tester 29 to start reading the stored Bitmap. The BIST 33 runs from a current window for all the possible windows, one by one.

In addition, the BIST 33 continues to run the March element, until all the words of the core 30 are exhausted. At the last word of the core 30, the BIST 33 waits for the tester to complete reading of the FIFO 31.

Once all the data has been read, the state machine 36 starts the BIST 33 from beginning of the March element of interest and makes the comparison accordingly.

Moreover, advantageously according to the invention, the PRASG 37 generates the address on which the read operation is performed on the core 30. The sequence generated can be a pseudo random pattern, which can be programmed by reseeding at the beginning of the memory test. The deterministic sequence can be programmed up to K number of read cycles per address, where the address sequence can be defined for M number of words for each read cycle.

The first and second counters, 34 and 35, are used to run the BIST 33 for, as many times as there are possible windows. The number of runs required is the division of the number of words in the memory by the number of words in the FIFO 31 chosen.

The serial pipe 32 is the interface in the parallel domain of the BIST 33 and the serial domain of the tester. If there are more pins, which can be dedicated for the debug and diagnostics purposes, the length of the serial pipe 32 can be reduced. The clock of the serial pipe 32 is that of the tester clock speed.

The Bitmap analysis system (BMAS) 40 according to the invention implements a method for high speed testing a memory device 30 comprising the steps of:
partitioning the memory device 30 into smaller equal sized segments;
sequentially generating bitmaps for the memory segments; and
storing the Bitmap result of each memory segment in a FIFO segment equivalent to the size of the memory segments after being extracted for analysis before generating a Bitmap for a next memory segment.

' More particularly, the following operation are provided:
1. A FIFO block 31 is used with N data bits and M words.
2. The BIST 33 runs at a high-speed clock and the faults are generated.
3. Thus, each time the BIST 33 runs a March element it runs on the whole memory device under test, but the memory output is only compared for M number of words and N number of data bits each time. The result of the comparison is stored in the FIFO 31 with M words of N word length.
4. The comparison response is stored for all the M words and the N bits in a window, either they fail or not. This creates a complete Bitmap of the window for a given March element run.
5. When one March element has been completed, the BIST 33 stops and sends a signal to the tester 39. Thus, the tester 39 reads the complete Bitmap of the M words and N bits of the memory under test 30, which is stored in the FIFO 31.
6. When the whole data has been stored in the tester 39, it gives a restart signal to the BIST 33.
7. The BIST 33 runs from the beginning of the March algorithm currently active and compares for the next set of M words and N bits in the same March element as previous.
8. The BIST 33 goes this way until the same March element has been run for all the possible windows of M words and N bits in the memory device 30.
9. After that, the BIST 33 runs the same for the next March element in the March algorithm, by taking each time next M words and N bits only.

Thus at the end, the tester 39 has a complete Bitmap of the memory device under test 30. In addition, the stimuli need not to be stored along with the faulty bit information stored on chip, since they are known to the tester 39.

It should be noted that the Bitmap has to be different for each comparison of the same word. Thus if there are k read/write operations to be done in one March element on the BIST 33 and where out of k, only x one operations will be measured by the BIST, identical FIFOs are needed for one set of Bitmap data

In summary, the Bitmap analysis system (BMAS) according to the invention provides a bit map analysis with low area overhead.

Moreover, the amount of data transaction between the BIST and the tester are reduced as well as the tester clock cycles, due to which the test timings are reduced drastically.

The Bitmap analysis system (BMAS) and the method according to the invention are worthy used inside embedded memories whether they are asynchronous or synchronous, static or dynamic, volatile or nonvolatile.

## Claims

1. A BitMap Analysis System (BMAS) for high-speed testing a memory device (30) comprising:
a test engine (38) connected to said memory device (30) for generating bitmaps; and
a First-In First-Out, or FIFO block (31) having a write terminal connected to said test engine (38) and a read terminal connected to a tester (39);
wherein
said memory device (30) is partitioned into small equal sized memory segments;
said FIFO block (31) contains at least one FIFO segment equivalent to the size of said memory segments; and
said test engine (38) sequentially generates and verifies the bitmaps of each of said memory segment.

2. A Bitmap analysis system (BMAS) as claimed in claim 1, wherein a serial pipe (32) of predetermined size is connected to said read terminal of said FIFO block (31) for reading and transmitting test results.

3. A Bitmap analysis system (BMAS) as claimed in claim 1, wherein said test engine (38) comprises at least a state machine (36) connected to said FIFO block (31) and to said tester (39) for controlling and managing handshake signals as well as a Built-in-Self-Test or BIST (33) connected to said state machine (36) for generating bitmap for said memory device (30) and said FIFO block (31).

4. A Bitmap analysis system (BMAS) as claimed in claims 2 and 3, wherein said FIFO memory device (31) has a matrix structure with M words and N data bits and is also connected to said serial pipe (32), which converts N bits to 1-bit information per tester clock, said serial pipe (32) having an output terminal connected to said tester (29).

5. A Bitmap analysis system (BMAS) as claimed in claim 4, wherein said test engine (38) further comprises:
a first counter (34) connected to said state machine (36) for counting up to a total number of words of said memory device (30) divided by M; and
a second counter (35) connected to said state machine (36) for counting up to total number of Bits of said memory device (30) divided by N,
said first and second couriters (34, 35) being used to run said BIST (33).

6. A Bitmap analysis system (BMAS) as claimed in claim 5, wherein said test engine (38) further comprises a programmable read address sequence generator or PRASG (37) serially interfaced to said tester (39) for generating an address sequence.

7. A method for high speed testing a memory device (30) comprising the steps of:
partitioning said memory device (30) into smaller equal sized segments;
sequentially generating bitmaps for said memory segments; and
storing said bitmap result of each said memory segment in a FIFO segment equivalent to the size of said memory segments after being extracted for analysis before generating a bitmap for a next memory segment.

8. A method for high speed testing a memory device (30) as claimed in claim 7, further comprising the step of transmitting stored results to a tester (39) by using a serial pipe (32) of predetermined size.
